# EUROPEAN PATENT SPECIFICATION

(11) **EP 0 929 921 B1**
(45) Date of publication and mention of the grant of the patent: **25.06.2003**
(21) Application number: 97910719.0
(22) Date of filing: 26.09.1997
(51) Int. Cl.: H01S 5/32, H01L 21/465, H01L 33/00

(54) **A MAGNESIUM CONTAINING II-VI SEMICONDUCTOR DEVICE AND ITS FABRICATION METHOD**
EINE MAGNESIUMHALTIGE VORRICHTUNG AUS EINEM II-VI VERBINDUNGSHALBLEITER UND DEREN HERSTELLUNGSVERFAHREN
COMPOSANT SEMICONDUCTEUR II-VI CONTENANT DU MAGNESIUM ET PROCEDE DE FABRICATION DE CE COMPOSANT

(30) Priority: 07.10.1996 US 726731; 09.09.1997 US 929221
(43) Date of publication of application: 21.07.1999
(73) Proprietor: MINNESOTA MINING AND MANUFACTURING COMPANY, St. Paul, Minnesota 55133-3427 (US)
(72) Inventor: HAASE, Michael, A., Saint Paul, MN 55133-3427 (US); BAUDE, Paul, F., Saint Paul, MN 55133-3427 (US); MILLER, Thomas, J., Saint Paul, MN 55133-3427 (US)
(74) Representative: VOSSIUS & PARTNER
(86) International application number: US9717364
(87) International publication number: WO98015996

(56) References cited:
- EP-A- 0 619 602
- US-A- 5 488 233
- HAASE M A ET AL: "LOW-THRESHOLD BURIED-RIDGE II-VI LASER DIODES" APPLIED PHYSICS LETTERS, vol. 63, no. 17, 25 October 1993, pages 2315-2317, XP000408794
- PATENT ABSTRACTS OF JAPAN vol. 095, no. 003, 28 April 1995 & JP 06 342960 A (SONY CORP), 13 December 1994,
- PATENT ABSTRACTS OF JAPAN vol. 097, no. 009, 30 September 1997 & JP 09 139549 A (HITACHI LTD), 27 May 1997,
- PATENT ABSTRACTS OF JAPAN vol. 096, no. 009, 30 September 1996 & JP 08 122701 A (MORITETSUKUSU:KK), 17 May 1996,
- M. SHIRAISHI ET AL: "Defect studies in ZnSSe and ZnMgSSe by chamical etching and transmission electron spectroscopy" PHYSICA STATUS SOLIDI A, vol. 152, no. 2, 16 December 1995, GERMANY, pages 377-383, XP002054832

## Description

### TECHNICAL FIELD

The present invention relates generally to II-VI semiconductor devices. In particular, the present invention is a method of fabricating a magnesium-containing II-VI compound semiconductor device and a magnesium-containing II-VI semiconductor device.

### BACKGROUND OF THE INVENTION

Buried ridge (buried heterostructure) semiconductor devices are known. Such devices are useful in constructing light emitting or detecting devices, diodes and laser diodes such as those described in U.S. Patent No. 5,213,998, issued May 25, 1993; U.S. Patent No. 5,248,631, issued September 28, 1993; U.S. Patent No. 5,274,269, issued December 28, 1993; U.S. Patent No. 5,291,507, issued March 1, 1994; U.S. Patent No. 5,319,219, issued June 7, 1994; U.S. Patent No. 5,395,791, issued March 7, 1995; U.S. Patent No. 5,396,103, issued March 7, 1995; U.S. Patent No. 5,404,027, issued April 4, 1995; U.S. Patent No. 5,363,395, issued November 8, 1994; U.S. Patent No. 5,515,393, issued May 7, 1996; U.S. Patent No. 5,420,446, issued May 30, 1995; U.S. Patent No. 5,423,943, issued June 13, 1995; U.S. 5,538,918, issued July 23, 1996; and U.S. 5,513,199, issued April 30, 1996.

Various techniques have been used in the manufacturing of such devices. One such technique is a dry etch process using Xe ion beam etching to provide the desired surface features. In ion beam etching, a mask layer covers a portion of the semiconductor. The ion beam is used to sputter off the exposed portions of the semiconductor. The portions of the semiconductor that are covered by the mask are not etched. Following the ion etch, the mask is removed, thereby exposing the underlying, unetched material. Overall, ion milling solves anisotropy and resolution limits of wet and dry chemical etch approaches, and can be well controlled with respect to major variables that affect etch performance, such as etch rate and end-point detection. In U.S. Patent Nos. 5,420,446 and 5,423,943, F. Naria and M. Ozawa teach the use of reactive ion etching (RIE) to achieve selective etching of II-VI layers. In this technique it is found that RIE etches II-VI compounds slower if they contain Mg.

However, ion etching can damage the device. For example, the use of such ion beam etching can lead to accelerated degradation at the edges of the laser ridge. Such damage can lead to reduction in luminescence for laser diode semiconductor devices, as well as increased failure rate of such devices.

Another etching technique uses a chemical etchant which reacts with the deposited layers. Chemical etches typically cause less damage to the device than ion beam etching. (In this context, reference is made to US-A-5, 488, 233). However, the art has lacked a chemical etch which is compatible-with, and suitable for use in II-VI semiconductor fabrication. Additionally, there is a need for a selective etch process for II-VI semiconductors.

### SUMMARY OF THE INVENTION

The present invention is specified in the claims.

Briefly, in one aspect of the present invention, a process for fabricating a II-VI compound semiconductor device is provided comprising the steps: (a) providing a first epitaxial layer of II-VI semiconductor on a substrate, and a second epitaxial layer of II-VI semiconductor, wherein the second layer includes magnesium (Mg) and the magnesium content of the second layer is greater than that of the first layer, (b) providing an imagewise mask of photoresist proximate to the second epitaxial layer, and (c) selectively etching the second epitaxial layer with an aqueous solution that includes HX, wherein X is either chlorine (Cl) or bromine (Br).

Furthermore, the second layer may be partially ion beam etched prior to selectively etching with HX. Advantageously, initial etching with ion beam provides for high resolution and an accelerated etch rate, while final selective etching using HX removes any damage caused by the ion beam etching. Similarly, reactive ion etching or other chemical etching may be used prior to etching with HX.

Because HX does not substantially etch the (100) surface of II-VI material that contains no Mg, over-etching and under-cutting is more controlled. Further, because of the selectivity to magnesium-containing layers, the selective etching process automatically stops (or slows significantly) at a precise depth when a magnesium-deficient layer is encountered.

One aspect of the invention includes a II-VI semiconductor device having layers containing different concentrations of Mg (including layers which contain no Mg) such that a layer of lower Mg concentration provides an etch stop layer to an HX etchant.

### BRIEF DESCRIPTION OF THE DRAWINGS

Figure 1 is a side cross-sectional view of a substrate carrying a buried-heterostructure II-VI compound semiconductor laser diode made in accordance with the present invention.
Figure 2 is a side cross-sectional view of the substrate of Figure 1 showing an initial processing step.
Figure 3 is a side cross-sectional view of the substrate of Figure 2 following an etching process.
Figure 4 is a side cross-sectional view of the substrate of Figure 3 following a subsequent selective chemical etch.
Figure 5 is a side cross-sectional view of the substrate of Figure 4 following deposition of a burying layer.
Figure 6 is a side cross-sectional view of the substrate of Figure 5 following a lift off process which removes portions of the burying layer.
Figure 7A and 7B are cross-sectional views of substrates which show positive and negative sloped profiles, respectively, made in accordance with the invention.

### DETAILED DESCRIPTION OF THE PREFERRED EMBODIMENTS

A manufacturable index-guided laser is required for all blue-green laser applications in which the optical quality of the beam, or the threshold current is an important issue. The process described here enhances the manufacturability and the reliability of these devices.

The method of the invention is useful in fabricating blue-green laser diodes wherein a selective wet etching step is included. Previous work has lead to the development of a buried ridge laser diode process. That process included ion beam etching using Xe ions. The ion beam may damage the device and may lead to accelerated degradation at the edges of the laser ridge. The present invention is directed toward a wet etching step that removes damaged portions of the layer. The process uses an aqueous HX solution as an etchant where X is Cl or Br. In addition, this process has an advantage in that it selectively etches MgZnSSe cladding layers, and does not etch the underlying ZnSSe guiding layer of a II-VI laser diode. Thus, the etching process automatically stops at the precise depth desired for a practical index-guided ridge laser.

The prior art includes index-guided lasers, ion beam etching, and wet chemical etching. However, it is believed that the following have not been previously reported: 1) ion beam etching may lead to accelerated device degradation; 2) HX etches MgZnSSe; 3) HX does not etch the (100) surface of ZnSe or ZnSSe; 4) previously known II-VI etchants selectively etch ZnSeTe (used for contact layers) much faster than MgZnSSe, usually damaging the ZnSeTe graded contacts, whereas HX does not; and 5) points 2, 3 and 4 can be used to efficiently fabricate blue-green laser diodes. As used herein HX is either HCl or HBr in an aqueous solution.

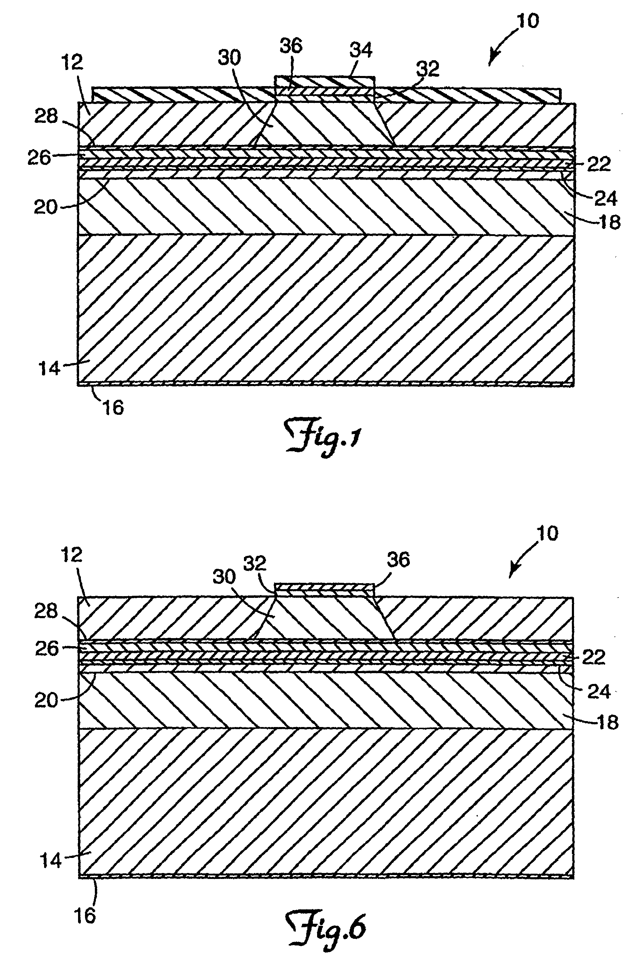

A buried-heterostructure II-VI compound semiconductor laser diode 10 prepared in accordance with the present invention is illustrated generally in Figure 1. As shown, laser diode 10 includes a ridge (typically 5 µm wide) having sides surrounded or "buried" by polycrystalline ZnS burying layer 12 to form a buried-ridge waveguide. The various layers of device 10 may be deposited by molecular beam epitaxy (MBE) as described in U.S. Patent Nos. 5,291,507 and 5,363,395. In another embodiment, Be can be incorporated into the layers as described in U.S. Patent No. 5,818,859, entitled BE-CONTAINING II-VI BLUE-GREEN LASER DIODES and filed on October 7, 1996.

Laser diode 10 is formed on a GaAs substrate 14 which is electrically coupled to metal contact 16. A lower MgZnSSe cladding layer 18 is deposited on GaAs substrate 14. Two ZnSSe waveguides 20 and 22 overly cladding layer 18 and are separated by a CdZnSSe quantum well 24. A first upper MgZnSSe cladding layer 26 overlies waveguide layer 22 and carries an etch stop layer 28. In one embodiment, etch stop layer 28 comprises ZnSSe. However, any appropriate II-VI material having a reduced concentration of Mg relative to cladding layer 18 may be used. Etch stop layer 28 is greater than 5 nm (50Å) thick and preferably 20 nm (200Å). If layer 28 is too thick, it may affect operation of laser diode 10. A second upper cladding layer 30 overlies etch stop layer 28 and is embedded in burying layer 12. ZnSeTe ohmic contact layer 32 is formed on cladding layer 30 and is covered by metal ohmic contact electrode 36. Metal bond pad 34 covers ohmic contact electrode 36.

In one embodiment, the epitaxial layers are as follows:

| LAYER | REFERENCE # | THICKNESS |
|---|---|---|
| ZnSeTe:N graded contact layer | Generally 32 | 50nm (500 Å) |
| ZnSe:N contact layer | Generally 32 | 0.1 µm |
| MgZnSSe:N cladding; | 30 | 0.8 µm |
| ZnSSe:N etch stop | 28 | 20nm (200 Å) |
| MgZnSSe:N cladding | 26 | 50nm (500 Å) |
| ZnSSe:N guiding layer; | 22 | 0.125 µm |
| CdZnSSe quantum well | 24 | 4nm (40 Å) |
| ZnSSe:Cl guiding layer; | 20 | 0.125 µm |
| MgZnSSe:Cl cladding; | 18 | 0.8 µm |
| ZnSe:Cl contact layer; | (Not shown) | 0.02 µm |
| GaAs:Si buffer layer | Generally 14 | |
| GaAs:Si substrate | Generally 14 | |

Fabrication of buried heterostructure 10 shown in Figure 1 begins with application of the layers necessary for fabricating a p-type ohmic contact electrode. Referring to Figure 2, ohmic contact electrode 36 comprises a 5 nm (50 Å) layer of palladium (Pd) covered by a 100 nm (1000 Å) layer of gold (Au). Atop the Au layer, a 1 nm (10 Å) layer of titanium (Ti) is deposited. The layers are deposited in a conventional vacuum evaporator. Ti layer, although not required, is particularly useful in improving photoresist adhesion.

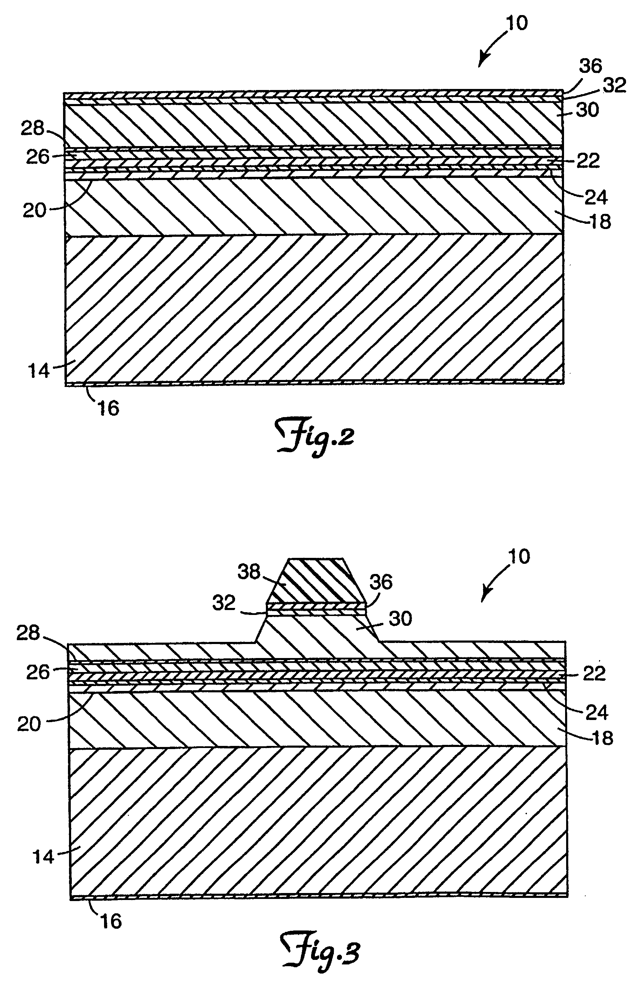

A mask 38 shown in Figure 3 is then applied atop the ohmic contact electrode. The size, width and positioning of this mask is dependent upon the final configuration of the heterostructures within the device 10. In one embodiment, Hoechst Celanese photoresist and associated process AZ-5214E is applied and patterned into 4 or 5 µm lines. The lines are oriented normal to the major flat on AXT™ GaAs wafers (<011>) available from American Crystal Technology located in Dublin California.

In one embodiment, the device 10 is then transferred to a vacuum chamber where an ion milling etching process is implemented to form the ridge from device 10. This is used to perform an initial etch through layers 36, 32 and into 30. An Xe⁺ ion source is used with a beam voltage of 500 volts. Device 10 is rocked ±50° during ion milling and the etch rate is 0.125 µm/min. The beam from a He-Ne laser is directed through a window in the vacuum chamber and impinged on device 10 during the etching process. The ion beam removes exposed portions of layers 30, 32 and 36 which are not covered by photoresist mask 38. Portions of the laser beam reflected from device 10 are detected and monitored to determine the etch depth. The ion milling process is described in U.S. Patent No. 5,404,027.

The etch depth is monitored with the He-Ne laser and is brought to within about 0.5 µm of layer 28. For the last 250 nm (2500 Å) or more, the ion beam voltage is reduced to 30 volts. At approximately 200 nm (2000 Å) before reaching the etch-stop layer 28, ion milling is stopped. The resulting structure is shown in Figure 3 and the top of layer 30 is damaged due to the milling process.

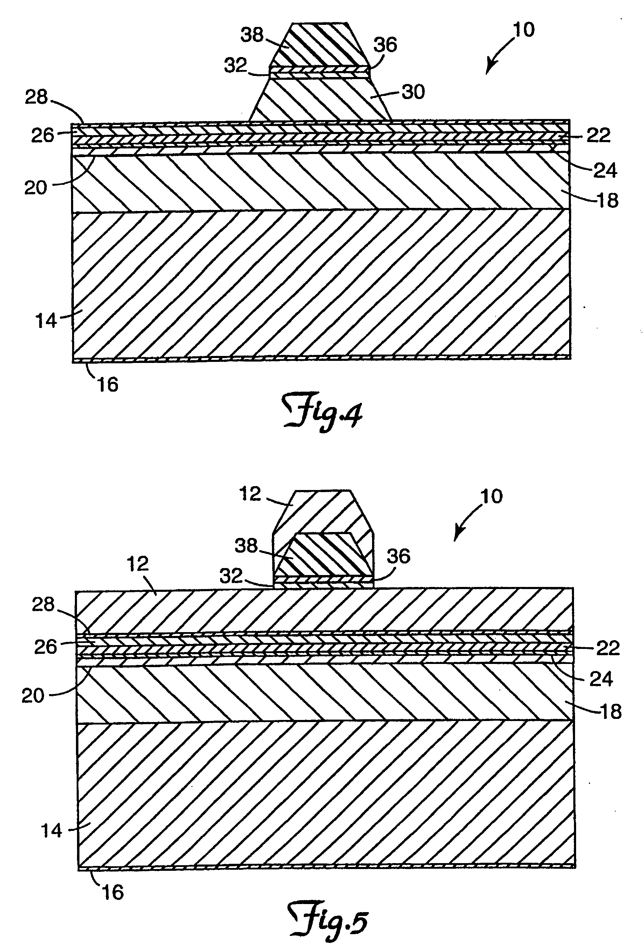

Device 10 is then removed from the vacuum chamber and immediately etched in an aqueous solution of HCl or HBr (concentration is determined by the amount of magnesium present in the etched layer) which selectively etches layer 30. In one embodiment, etching is performed at room temperature without stirring and occurs at a rate of about 150nm/s (1500 Å/sec) using "concentrated" HCl solution. Alternatively, the ion milling step may be replaced by other known etching techniques. In other embodiments, the selective chemical etch may be used to remove all of layer 30. Layer 30 is etched until etch-stop layer 28 is reached, at which point selective etching terminates. Device 10 is then removed from etchant solution rinsed and dried. This results in the structure shown in Figure 4. One aspect of the invention includes the additional etch stop layer 28 spaced apart from waveguide layer 22. This design reduces the number of minority carriers which recombine at the etched surface through dark recombination (i.e., recombination which does not provide luminescence) during operation of the laser diode thereby improving device efficiency. In another embodiment, a separate etch stop layer is not used and waveguide layer 22 acts as an etch stop layer. In either embodiment, waveguide layer 22 is substantially unetched by the HX.

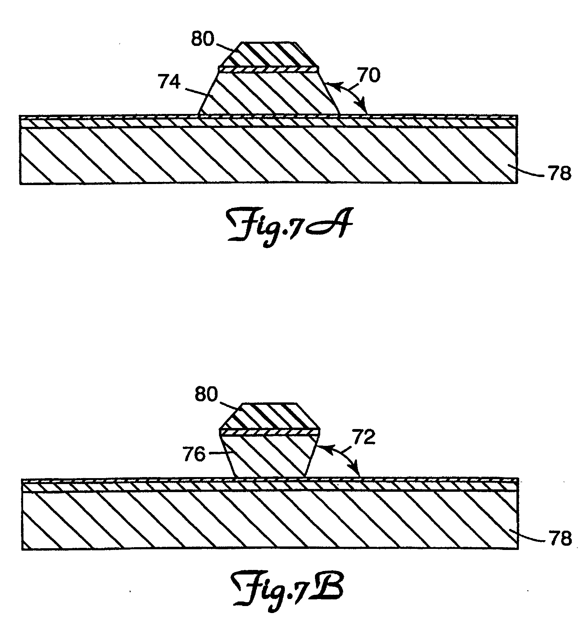

Once the heterostructure is defined by the etching process, burying layer 12 is deposited. Referring to Figure 5, a 1 µm layer 12 of polycrystalline ZnS is deposited. Photoresist solvent is applied causing mask layer 38 to "lift off" thereby removing layer 38 along with the portion of layer 12 which overlies layer 38. Ultrasound and acetone may be used to cause the lift off. It may also be desired to ion etch device 10 to partially remove layer 12 and thereby expose a portion of photoresist layer 38 to facilitate lift off. However, this may not be necessary if there is sufficient undercutting from the HX process. This lift-off process exposes layer 36 as shown in Figure 6.

Referring back to Figure 1, a bond pad 34 is applied using standard techniques. For example, a 100 nm (1000 Å) layer of Ti followed by a 200nm (2000 Å) layer of Au is then deposited.

One important aspect of the invention is that the HX will anisotropically etch the side walls of the waveguide ridge. The resulting profile will evolve towards either an obtuse wall angle 70 as shown in Figure 7A or an acute wall angle 72 as shown in Figure 7B, depending on the crystallographic orientation of the ridge 74 or 76, respectively carried on substrate 78. The HX etching tends to reveal a slow-etching {111} plane. If ridge 74 is aligned with the <011> crystallographic direction (depending on the manufacturer, this is either parallel or perpendicular to the major flat on the wafer), undercutting results in obtuse side-wall angle 70 of about 125°. This geometry is preferred for processes that involve subsequent vacuum deposition of a burying layer. On the other hand, if ridge 76 is aligned parallel to the <011> direction, undercutting results in an acute side-wall angle 72 of about 55°. This may be preferred for some applications. Advantageously, p-type contact 80 is larger than the active region which provides a lower series resistance for a given active area.

The particular etch rate of the selective etch may be adjusted by controlling the concentration of Mg in the layer to be etched or by controlling the concentration of the HX solution. Concentrations of aqueous HX solutions useful in the invention can be in the range of 0.1N to concentrated (saturated) solution. Preferably, HCl concentrations range from 1N to 12N, more preferably from 5N to 12N, even more preferably from 10N to 12N and most preferably 12N (i.e., "concentrated HCl"). Preferably, HBr concentrations range from 1N to 8N, more preferably from 6N to 8N, and more preferably 8N (i.e., "concentrated HBr"). Mg concentration may be determined by observing the bandgap of the material which, in one embodiment, is 2.85 eV, about 8%. In other embodiments, the layer that is etched by HX is, for example, MgZnSSe, MgZnSe, BeMgZnSe, or BeMgZnSSe.

The present invention offers advantages over the art in that it provides a useful photolithographic process and apparatus to form desired shapes in II-VI semiconductor material. The invention is useful with any II-VI device and is not limited to the laser diode set forth herein. For example, it is useful in the fabrication of II-VI heterojunction bipolar transistors to enable contact to the base. Further, the invention includes the resultant structure formed by the aforementioned etching process, including those devices which contain an etch stop layer following the fabrication process.

Those skilled in the art will recognize that any appropriate etch stop layer may be used which etches at a rate which is less than the etch rate of the material to be removed, including a layer with a lower relative concentration of Mg. Generally, the etch stop should be selected such that it is compatible with the process or finished product. It will also be understood that the etch stop layer may be removed using any appropriate technique prior to completion of the fabrication process.

Although the present invention has been described with reference to preferred embodiments, workers skilled in the art will recognize that changes may be made in form and detail without departing from the scope of the invention. II-VI semiconductor devices in accordance with the present invention are useful in electronic devices, electronic systems, optical data disk storage system, communications systems, electronic display system, laser pointers, etc.

## Claims

1. A method of fabricating a II-VI compound semiconductor device comprising the steps:
providing a first layer of II-VI semiconductor;
providing a second layer of II-VI semiconductor adjacent to the first layer, wherein the second layer includes magnesium (Mg) and a Mg content of the second layer is greater than a Mg content of the first layer;
providing a mask proximate the second layer; and
selectively etching unmasked portions of said second layer with an aqueous solution that includes HX, wherein X is either chlorine or bromine.

2. The method of claim 1, wherein the second layer is partially ion beam etched prior to said step of selectively etching.

3. The method of claim 1,
wherein the second layer comprises BeMgZnSe or MgZnSe or BeMgZnSSe.

4. The method of claim 1, further comprising, prior to said etching step, depositing a third layer upon the mask and subsequently lifting off a portion of the third layer by removing the mask,

5. The method of claim 1,
wherein the mask comprises photoresist.

6. The method of claim 1, further comprising the step:
providing an angle to a sidewall of the second layer by selectively aligning the mask with a crystal orientation of the second layer, wherein the angle is about 55° or about 125°.

7. The method of claim 4, 5 or 6, wherein the second layer comprises MgZnSSe.

8. The method of claim 4, 5 or 6, wherein the second layer comprises BeMgZnSe.

9. The method of claim 4, 5 or 6, wherein the second layer comprises MgZnSe.

10. The method of claim 4, 5 or 6, wherein the second layer comprises BeMgZnSSe.

11. The method of any of claims 3 to 10, wherein the second layer is partially ion beam etched prior to said step of selectively etching.

12. The method of any of claims 1 to 10, wherein the second layer is partially reactive ion etched prior to said step of selectively etching.

13. The method of any of claims 1 to 10, wherein the second layer is partially chemically etched prior to said step of selectively etching.

14. The method of any of claims 1 to 13, including providing additional layers to form a II-VI laser diode.

15. The method of any of claims 1 to 14 wherein the second layer comprises a cladding layer of the laser diode.

16. The method of any of claims 1 to 15, wherein the first layer comprises a guiding layer of the laser diode.

17. The method of any of claims 1 to 16 including depositing a third layer upon the mask and subsequently lifting off a portion of the third layer by removing the mask.

18. The method of any of claims 1 to 4 and 6 to 17 wherein the mask comprises photoresist.

19. The method of any of claims 1 to 5 and 7 to 18 including providing an angle to a sidewall of the second layer by selectively aligning the mask with a crystal orientation of the second layer.

20. The method of claim 19 wherein the angle is about 55°

21. The method of claim 19 wherein the angle is about 125°.

22. The method of any of claims 1 to 21 wherein the first layer has a thickness of more than about 5nm (50 Å).

23. A II-VI semiconductor device, comprising:
a first cladding layer of II-VI semiconductor;
a first guiding layer of II-VI semiconductor overlying the first cladding layer;
an active region of II-VI semiconductor overlying the first guiding layer;
a second guiding layer of II-VI semiconductor overlying the active region;
a second cladding layer of II-VI semiconductor overlying the second guiding layer, wherein the second cladding layer includes Mg; and
an etch stop layer carried in the second cladding layer, wherein the etch stop layer contains a concentration of Mg which is less than a concentration of Mg in the second cladding layer.

24. A II-VI semiconductor device according to claim 23 wherein the second cladding layer includes a side wall substantially parallel to a {111} crystallographic plane of the second cladding layer.

25. The II-VI semiconductor device according to claim 23 or 24 wherein the etch stop layer has a thickness of at least 5 nm (50Å).

## Patentansprüche

1. Verfahren zur Herstellung eines Halbleiterbauelements aus II-VI-Verbindungen, mit den folgenden Schritten:
Ausbilden einer ersten Schicht aus einem II-VI-Halbleiter;
Ausbilden einer zweiten Schicht aus einem II-VI-Halbleiter angrenzend an die erste Schicht, wobei die zweite Schicht Magnesium (Mg) enthält und ein Mg-Gehalt der zweiten Schicht größer ist als ein Mg-Gehalt der ersten Schicht;
Ausbilden einer Maske in unmittelbarer Nähe der zweiten Schicht; und
selektives Ätzen von unmaskierten Abschnitten der zweiten Schicht mit einer wäßrigen Lösung, die HX enthält, wobei X entweder Chlor oder Brom ist.

2. Verfahren nach Anspruch 1, wobei die zweite Schicht vor dem selektiven Ätzschritt teilweise ionenstrahlgeätzt wird.

3. Verfahren nach Anspruch 1, wobei die zweite Schicht BeMgZnSe oder MgZnSe oder BeMgZnSSe aufweist.

4. Verfahren nach Anspruch 1, das ferner vor dem Ätzschritt das Aufbringen einer dritten Schicht auf die Maske und das anschließende Abheben der dritten Schicht durch Entfernen der Maske aufweist.

5. Verfahren nach Anspruch 1, wobei die Maske einen Photoresist aufweist.

6. Verfahren nach Anspruch 1, das ferner den Schritt zum Ausbilden eines Winkels zu einer Seitenwand der zweiten Schicht durch selektives Ausrichten der Maske auf eine Kristallorientierung der zweiten Schicht aufweist, wobei der Winkel etwa 55° oder etwa 125° beträgt.

7. Verfahren nach Anspruch 4, 5 oder 6, wobei die zweite Schicht MgZnSSe aufweist.

8. Verfahren nach Anspruch 4, 5 oder 6, wobei die zweite Schicht BeMgZnSe aufweist.

9. Verfahren nach Anspruch 4, 5 oder 6, wobei die zweite Schicht MgZnSe aufweist.

10. Verfahren nach Anspruch 4, 5 oder 6, wobei die zweite Schicht BeMgZnSSe aufweist.

11. Verfahren nach einem der Ansprüche 3 bis 10, wobei die zweite Schicht vor dem selektiven Ätzschritt teilweise ionenstrahlgeätzt wird.

12. Verfahren nach einem der Ansprüche 1 bis 10, wobei die zweite Schicht vor dem selektiven Ätzschritt teilweise durch reaktives Ionenstrahlätzen geätzt wird.

13. Verfahren nach einem der Ansprüche 1 bis 10, wobei die zweite Schicht vor dem selektiven Ätzschritt teilweise chemisch geätzt wird.

14. Verfahren nach einem der Ansprüche 1 bis 13, das die Ausbildung zusätzlicher Schichten zur Bildung einer II-VI-Laserdiode einschließt.

15. Verfahren nach einem der Ansprüche 1 bis 14, wobei die zweite Schicht eine Ummantelungsschicht der Laserdiode aufweist.

16. Verfahren nach einem der Ansprüche 1 bis 15, wobei die erste Schicht eine Führungsschicht der Laserdiode aufweist.

17. Verfahren nach einem der Ansprüche 1 bis 16, welches das Aufbringen einer dritten Schicht auf die Maske und das anschließende Abheben eines Teils der dritten Schicht durch Entfernen der Maske einschließt.

18. Verfahren nach einem der Ansprüche 1 bis 4 und 6 bis 17, wobei die Maske einen Photoresist aufweist.

19. Verfahren nach einem der Ansprüche 1 bis 5 und 7 bis 18, welches das Ausbilden eines Winkels zu einer Seitenwand der zweiten Schicht durch selektives Ausrichten der Maske auf eine Kristallorientierung der zweiten Schicht einschließt.

20. Verfahren nach Anspruch 19, wobei der Winkel etwa 55° beträgt.

21. Verfahren nach Anspruch 19, wobei der Winkel etwa 125° beträgt.

22. Verfahren nach einem der Ansprüche 1 bis 21, wobei die erste Schicht eine Dicke von mehr als etwa 5 nm (50 Å) aufweist.

23. Halbleiterbauelement aus II-VI-Verbindungen, das aufweist:
eine erste Ummantelungsschicht aus einem II-VI-Halbleiter;
eine über der ersten Ummantelungsschicht liegende erste Führungsschicht aus einem II-VI-Halbleiter;
einen über der ersten Führungsschicht liegenden aktiven Bereich aus einem II-VI-Halbleiter;
eine über dem aktiven Bereich liegende zweite Führungsschicht aus einem II-VI-Halbleiter;
eine über der zweiten Führungsschicht liegende zweite Ummantelungsschicht aus einem II-VI-Halbleiter, wobei die zweite Ummantelungsschicht Mg enthält; und
eine in der zweiten Ummantelungsschicht getragene Ätzstoppschicht, wobei die Ätzstoppschicht eine Mg-Konzentration enthält, die niedriger ist als eine Mg-Konzentration in der zweiten Ummantelungsschicht.

24. Halbleiterbauelement aus II-VI-Verbindungen nach Anspruch 23, wobei die zweite Ummantelungsschicht eine Seitenwand aufweist, die im wesentlichen parallel zu einer kristallographischen {111}-Ebene der zweiten Ummantelungsschicht ist.

25. Halbleiterbauelement aus II-VI-Verbindungen nach Anspruch 23 oder 24, wobei die Ätzstoppschicht eine Dicke von mindestens 5 nm (50 Å) aufweist.

## Revendications

1. Procédé de fabrication d'un composant semi-conducteur II-VI comprenant les étapes consistant à :
prévoir une première couche de semi-conducteur II-VI ;
prévoir une deuxième couche de semi-conducteur II-VI adjacente à la première couche, dans laquelle la deuxième couche comprend du magnésium (Mg) et dans laquelle une teneur en Mg de la deuxième couche est supérieure à une teneur en Mg de la première couche ;
prévoir un masque à proximité de la deuxième couche ; et
à graver sélectivement des portions non masquées de ladite deuxième couche avec une solution aqueuse qui comprend du HX, dans laquelle X est soit du chlore, soit du brome.

2. Procédé selon la revendication 1, dans lequel la deuxième couche est partiellement gravée par faisceau d'ions avant ladite étape de gravure sélective.

3. Procédé selon la revendication 1, dans lequel la deuxième couche comprend du BeMgZnSe ou du MgZnSe ou du BeMgZnSSe.

4. Procédé selon la revendication 1, comprenant en outre, avant ladite étape de gravure, le dépôt d'une troisième couche sur le masque et le décollage consécutif d'une portion de la troisième couche en retirant le masque.

5. Procédé selon la revendication 1, dans lequel le masque comprend une résine photosensible.

6. Procédé selon la revendication 1, comprenant en outre l'étape consistant à :
prévoir un angle sur une paroi latérale de la deuxième couche en alignant sélectivement le masque avec l'orientation d'un cristal de la deuxième couche, dans lequel l'angle est d'environ 55° ou d'environ 125°.

7. Procédé selon la revendication 4, 5 ou 6, dans lequel la deuxième couche comprend du MgZnSSe.

8. Procédé selon la revendication 4, 5 ou 6, dans lequel la deuxième couche comprend du BeMgZnSe.

9. Procédé selon la revendication 4, 5 ou 6, dans lequel la deuxième couche comprend du MgZnSe.

10. Procédé selon la revendication 4, 5 ou 6, dans lequel la deuxième couche comprend du BeMgZnSSe.

11. Procédé selon l'une quelconque des revendications 3 à 10, dans lequel la deuxième couche est partiellement gravée par faisceau d'ions avant ladite étape de gravure sélective.

12. Procédé selon l'une quelconque des revendications 1 à 10, dans lequel la deuxième couche est partiellement gravée par ions réactifs avant ladite étape de gravure sélective.

13. Procédé selon l'une quelconque des revendications 1 à 10, dans lequel la deuxième couche est partiellement gravée chimiquement avant ladite étape de gravure sélective.

14. Procédé selon l'une quelconque des revendications 1 à 13, comprenant la fourniture de couches supplémentaires pour former une diode laser II-VI.

15. Procédé selon l'une quelconque des revendications 1 à 14, dans lequel la deuxième couche comprend une couche de gainage de la diode laser.

16. Procédé selon l'une quelconque des revendications 1 à 15, dans lequel la première couche comprend une couche de guidage de la diode laser.

17. Procédé selon l'une quelconque des revendications 1 à 16 comprenant le dépôt d'une troisième couche sur le masque et le décollage consécutif d'une portion de la troisième couche en retirant le masque.

18. Procédé selon l'une quelconque des revendications 1 à 4 et 6 à 17, dans lequel le masque comprend une résine photosensible.

19. Procédé selon l'une quelconque des revendications 1 à 5 et 7 à 18 comprenant la fourniture d'un angle sur une paroi latérale de la deuxième couche en alignant sélectivement le masque avec l'orientation d'un cristal de la deuxième couche.

20. Procédé selon la revendication 19, dans lequel l'angle est d'environ 55°.

21. Procédé selon la revendication 19, dans lequel l'angle est d'environ 125°.

22. Procédé selon l'une quelconque des revendications 1 à 21, dans lequel la première couche possède une épaisseur supérieure à environ 5 nm (50 Å).

23. Semi-conducteur II-VI comprenant :
une première couche de gainage de semi-conducteur II-VI ;
une première couche de guidage de semi-conducteur II-VI chevauchant la première couche de gainage ;
une région active de semi-conducteur II-VI chevauchant la première couche de guidage ;
une deuxième couche de guidage de semi-conducteur II-VI chevauchant la région active ;
une deuxième couche de gainage de semi-conducteur II-VI chevauchant la deuxième couche de guidage, dans lequel la seconde couche de gainage contient Mg ; et
une couche d'arrêt de la gravure se trouvant dans la deuxième couche de gainage, dans lequel la couche d'arrêt de la gravure contient une concentration en Mg qui est inférieure à une concentration en Mg dans la deuxième couche de gainage.

24. Semi-conducteur II-VI selon la revendication 23, dans lequel la deuxième couche de gainage comprend une paroi latérale sensiblement parallèle à un plan cristallographique (111) de la deuxième couche de gainage.

25. Semi-conducteur II-VI selon la revendication 23 ou 24, dans lequel la couche d'arrêt de la gravure possède une épaisseur d'au moins 5 nm (50 Å).
